# EUROPEAN PATENT APPLICATION

(11) **EP 4 393 759 A1**
(43) Date of publication of application: **03.07.2024**
(21) Application number: 22217383.3
(22) Date of filing: 30.12.2022
(51) Int. Cl.: B60L 53/16, H01R 13/00, B60L 53/10, B60L 53/18, B60L 53/302, B60L 53/31, H01R 9/11

(54) **FLUID CHANNEL ASSEMBLY FOR AN EV CHARGING GUN CONNECTOR, CHARGING GUN AND CHARGING STATION**

(71) Applicant: ABB SCHWEIZ AG, 5400 Baden (CH)
(72) Inventor: SIMONETTI, Marco, 5443 Niederrhodorf (CH); GAUTSCHI, Simon, 5408 Ennetbaden (CH); GARCIA-FERRE, Francisco, 5400 Baden (CH)
(74) Representative: Maiwald GmbH

(57) **Abstract**

The invention relates to a fluid channel assembly (100) for an Electric Vehicle (EV) charging gun. The fluid channel assembly (100) comprises a fluid channel network (102) for cooling a contact pin (330) of the EV charging gun (804), a fluid inlet (112) connected to the fluid channel network, and configured to receive a coolant through an EV charging cable (600) and to inject the coolant to the fluid channel network, and at least one fluid outlet (114) connected to the fluid channel network, and configured to receive a coolant from the fluid channel network and to inject the coolant to the EV charging cable. The fluid channel network is configured to be arranged around the contact pin in direct or indirect contact with the contact pin (330).

## Description

### Technical Field

The invention relates to a fluid channel assembly for a connector of an Electric Vehicle (EV) charging gun, a connector for an EV charging gun, a charging gun for an EV charging station, a charging gun, and a use of a fluid channel network in an EV connector.

### Background

In charging systems with outputs up to 1250 V and 3000 A, which means more than 3 MW of electric power, even if electrical resistance of cable and connector system is of the order of magnitude of mOhm, heating due to Joule effect cannot be negligeable and particular attention must be paid to the thermal design of this system. For instance, for a 3 m cable with 105 mm² of copper cross-section per pole with a current of 3000 A more than 9 kW of heat are generated inside the cable and connector system, active cooling becomes essential.

### Summary of the invention

An improved charging connector for an EV charging station may be desired.

The problem is solved by the subject-matter of the independent claims. Embodiments are provided by the dependent claims, the following description and the accompanying figures.

The described embodiments similarly pertain to the fluid channel assembly for a connector of the Electric Vehicle (EV) charging gun, the connector for an EV charging gun, the charging gun for an EV charging station, the charging gun, and the use of a fluid channel network in an EV connector. Synergetic effects may arise from different combinations of the embodiments although they might not be described in detail.

Technical terms are used by their common sense. If a specific meaning is conveyed to certain terms, definitions of terms will be given in the following in the context of which the terms are used.

According to a first aspect, a fluid channel assembly for a connector of an Electric Vehicle (EV) charging gun, i.e., a charging gun socket, is provided. The fluid channel assembly comprises a fluid channel network for cooling a contact pin of the EV charging gun, and a fluid inlet, which is connected to the fluid channel network and which is configured to receive a coolant through an EV charging cable and to inject the coolant into the fluid channel network. The fluid channel assembly further comprises a fluid outlet, which is connected to the fluid channel network and which is configured to receive a coolant from the fluid channel network and to inject the coolant into the EV charging cable. The fluid channel network is arranged around the contact pin and the fluid in the channel network is in direct contact with the contact pin.

The fluid channel assembly may be realized, for example, as tubes, bores, covered grooves in a conductor, or as a structure mounted on a conductor forming channels where one side of the channel is the surface of the conductor, or any combination of these or further realization possibilities. The channel network part of the fluid channel assembly is designed such that the coolant is in direct or indirect contact with the contact pin, i.e., the current conducting material such as copper. The fluid may be, for example, a liquid or a vapor coolant. A contact pin in this disclosure is the pin of a female connector or female gun socket intended for getting in electrical contact with the male socket counterpart on vehicle side. The contact pin has a cylindrical shape and is at least partly hollow inside such that it can receive the solid contact pin of the vehicle socket. The EV charging gun has a fix connection to a charging cabinet of an EV charging cabinet. The cabinet and the EV charging gun including a cable forms an EV charging station.

The fluid inlet receives the fluid over the charging cable from the charging cabinet, and is configured to guide the fluid to the channel network. The fluid in channel network receives the heat from the contact pin and transports the heat away from the contact pin by flowing further in the opposite direction to the outlet. From the outlet, the fluid flows again through the cable back to the charging cabinet.

In this disclosure, the term "inlet" refers to an inflow tube connector, which is the inlet port of the coolant. Accordingly, the term "outlet" refers to outflow tube connectors, which are the outlet ports of the coolant. The term is used as collective term for all outflow tube connectors of one DC connector. A DC connector is either a DC+ connector or a DC- connector. It receives the wires of the cable and comprises the contact pins, including the fluid network channel. The charging gun therefore has two such connectors, one for DC+ and in parallel, one for DC-. The contact pin may also be referred to as contact tip or as "tulip". It is the contact part of the connector. The contact pin is cooled in direct contact with the coolant. Radial holes may be used as inlet/outlet ports of the coolant.

The fluid channel assembly represents therefore a hydraulic circuit where a coolant is provided from the charging cabinet over the cable to the EV connector. Inside the connector, the coolant is driven through the inlet and through the channel network to the outer end of the contact pin to cool directly the contact pin.

This network of channels, which are - as described further below - hydraulically in parallel has been designed and proposed to lead the lowest pressure loss keeping the opportunity to have a large heat transfer surface, which is also called "wet surface".

According to an embodiment, the inlet is connected via a first single fluid transfer channel with the fluid channel network.

The fluid channel assembly consists essentially of three parts: the inlet and outlet part, the channel network, and a connection in between, consisting of channels that are called "transfer channels" in this disclosure. For the inlet, there is only one transfer channel, i.e., a single channel, before the path splits into, for example, two channels at the entry of the channel network.

According to an embodiment, the at least one outlet is connected via a second single fluid transfer channel with the fluid channel network.

Similar to the inlet, also between the outlet that may comprise, for example, three outflow tube connectors, and the channel network, a single transfer channel is provided. That is, the outlet may consist of several ports, which are joined at one end of the outlet transfer channel, and at the other end, channels from the channel network are joined.

According to an embodiment, the fluid channel network has main channels parallel to the axes of the contact pin and cross-link channels between the main channels.

The fluid channel network may be hydraulically composed of channels parallel to the cylinder axis of the contact pin and circumferential channels, which has the main advantage to decrease pressure loss, to keep large heat exchange surfaces. Furthermore, such network opens a panel of degree of freedoms to optimize the thermal behavior of the terminal by locally tuning the cross-section of each parallel channel. In this disclosure, the parallel channels are referred to as "main channels", and the circumferential channels are referred to as "cross-link" channels as they connect main channels with each other. "Parallel" may refer to the flow, i.e., the connection in parallel, and/or to the geometry.

According to an embodiment, each transfer channel splits into two main channels, and a part of the cross-link channels connects one of the main channels of the first single fluid transfer channel with a neighboring main channel of the second single fluid transfer channel.

In this way, two parallel fluid circuits are realized. One of the split main channels of the first transfer channel is connected by a part of the cross-link channels with one of the split main channels of the second transfer channel. Accordingly, the other one of the split main channels of the first transfer channel is connected by the remaining part of the cross-link channels with the other one of the split main channels of the second transfer channel. As a variant, more than two parallel circuits may be implemented.

According to an embodiment, the number of cross-link channels is two or more.

Having more than one cross-link one characteristic of the channel network. The network formed in this way is much more effective than a simple loop.

According to an embodiment, the fluid channel assembly comprises further a contact terminal between the inlet or outlet and the transfer channels. The fluid inlet and the fluid outlet are mounted on a first side of the contact terminal, and the first and second single fluid transfer channels are mounted on a second side of the contact terminal. The inlet is continued to the first single fluid transfer channel through the contact terminal. The second single fluid transfer channel in contrast is split into a plurality of outlet ports of the outlets inside the contact terminal. The contact terminal may be designed to be removable to improve after-sales operations such as aged contact spring change or failure repairs. The contact terminal may be manufactured by machining and assembled by brazing and/or welding.

According to a second aspect, a connector for an electric vehicle charging gun is provided. The connector comprises a fluid channel assembly as described herein comprising an inlet, an outlet, transfer channels and a fluid channel network, a contact pin, and a contact terminal. The contact terminal comprises an outlet for connecting outflow tubes, an inlet for connecting an inflow tube, and means for connecting the at least one copper conductor on a first side and means for connecting the contact pin on a second side, wherein the contact terminal is configured to accommodate the first and the second single fluid transfer channels. The fluid channel network is arranged around the contact pin and the fluid in the channel network is in direct contact with the DC contact pin.

According to an embodiment, the connector comprises three DC+ copper conductors and three DC- copper conductors. The three DC+ copper conductors, the three DC- copper conductors, and the inlet are part of a charging cable. The three DC- copper conductors and the three DC- copper conductors each are jacketed by an outflow tube. The three outflow tubes of the three DC+ copper conductors form an outlet of the fluid channel network of the DC+ contact pin. The three outflow tubes of the three DC- copper conductors form an outlet of the fluid channel network of the DC- contact pin.

According to an embodiment, the contact terminal further comprises a sleeve for the contact pin covering the contact pin. The channels of the fluid channel network are formed by grooves on the surface of the contact pin covered by the sleeve.

The sleeve corresponds to an outer part, which closes the hydraulic circuit. It may be made of the same material as the contact pin, for example copper.

According to a third aspect, a charging gun for an EV charging station is provided. The charging gun comprises a first connector as described herein and a second connector as described herein. The first connector is a DC+ connector for providing a positive DC pole, and the second connector is a DC- connector for providing a negative DC pole. The charging gun further comprises a charging cable with a least one DC+ conductor connected to the DC+ connector, at least one DC- conductor connected to the DC- connector, at least a first outflow tube, at least a second outflow tube, and an inflow tube. The at least one DC+ conductor is configured to receive the at least one first outflow tube, and the at least one first outflow tube is connected to the outlet of the DC+ contact terminal. The at least one DC-conductor is configured to receive the at least one second outflow tube, and the at least one second outflow tube is connected to the outlet of the DC- contact terminal.

The two connectors are hydraulically in parallel. The coolant directly flows from the cabinet to the connectors through the inlets of the two connectors for DC+ and DC-. Then, the coolant flows to the end of each of the contact pins thanks to the specific channel paths and finally it flows out from each connector to the cable through the outflow tubes that surround the conductors, for example, "x3" copper wires per pole. The poles are hydraulically parallel like the connectors.

According to an embodiment, the connector comprises three DC+ copper conductors and three DC- conductors. The three DC+ conductors, the three DC- conductors, and the inlet are part of a charging cable. The three DC- conductors and the three DC- conductors each are jacketed by an outflow tube. The three outflow tubes of the three DC+ conductors form an outlet of the fluid channel network of the DC+ contact pin. The three outflow tubes of the three DC- conductors form an outlet of the fluid channel network of the DC- contact pin

According to an embodiment, the charging cable further comprises a neutral line. The inflow tube is arranged centrally in the cable, and the three DC+ conductors, the three DC-conductors, and the neutral line are arranged are surrounding the inflow tube.

The fluid coolant tube is the tube that provides the coolant to the inlet.

According to a fourth aspect, a charging station comprising a connector as described herein is provided.

The charging station comprises a charging cabinet containing the electric circuits for providing the charging current. It further comprises a pump, which drives the fluid through the cable to the connector. The charging cabinet further comprises a holder for the removable connector that can be held by a user and plugged into the socket of an electric vehicle for charging the battery of the vehicle.

According to a fifth aspect, a use of a fluid channel network in an EV connector for cooling a contact pin of an EV connector is provided.

The fluid channel network is a network with channels, through which flows a fluid. The fluid may be a liquid or gaseous coolant. "Channel network" may be defined as a system of channels where the fluid can take more than one path from a first channel such as an inlet through the network to a second channel such as an outlet. "Direct" means that the fluid is in direct contact with the material, e.g. copper, of the contact pin. "Indirect" means that there is no direct contact, but the channel network is nevertheless arranged on the contact pin.

These and other features, aspects and advantages of the present invention will become better understood with reference to the accompanying figures and the following description.

### Short Description of the Figures

Fig. 1 shows a diagram of the fluid channel assembly.
Fig. 2 shows a diagram of the fluid flow in the fluid channel assembly.
Fig. 3 shows a diagram of a cross section of a DC connector for one polarity.
Fig. 4 shows a diagram of a DC connector for one polarity.
Fig. 5 shows a diagram of an assembly of a contact terminal and a contact pin.
Fig. 6 shows a diagram of a cable.
Fig. 7 shows a diagram of an alternative design of the contact pin.
Fig. 8 shows a diagram of a charging station.

### Detailed Description of Embodiments

Corresponding parts are provided with the same reference symbols in all figures.

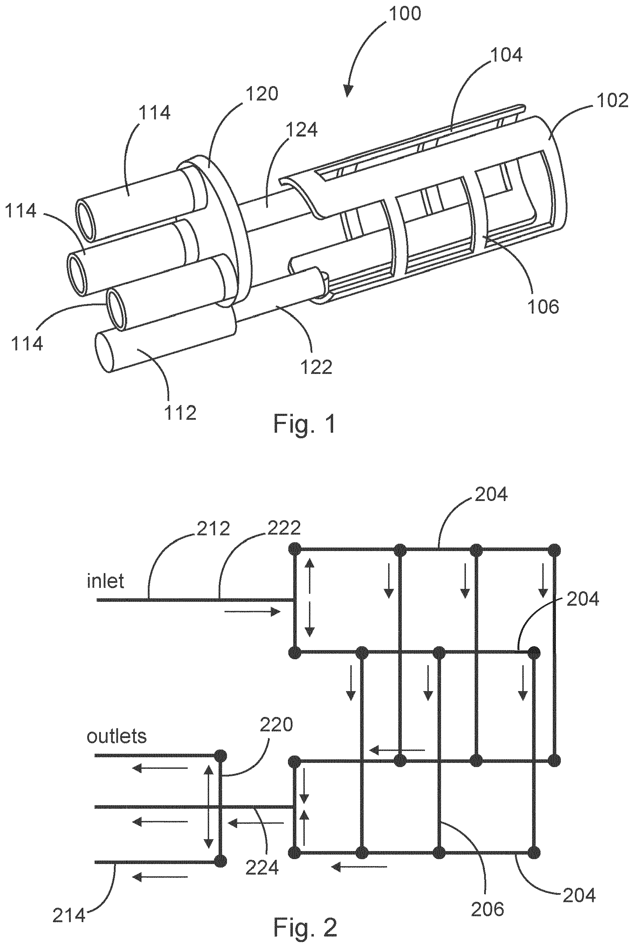

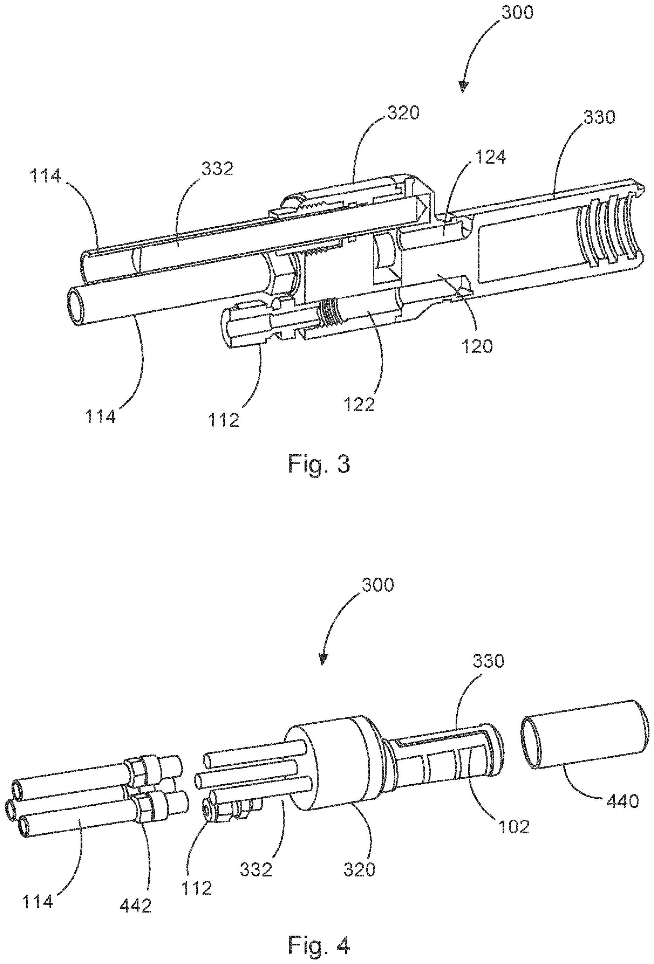

Fig. 1 shows the fluid channel assembly 100 for a connector for one polarity. The fluid channel assembly 100 comprises the fluid channel network 102, inlet 112, outlet 114, connection piece 120, a first single fluid transfer channel 122, and a second single fluid transfer channel 124. The outlet 114 consists, for example, of three channels representing inflow ports, in according with the number of DC conductors for the connector for one polarity. The inlet 112 and outlet 114 are oriented towards the charging station. The channel network 102 is oriented towards the vehicle when the charging gun is plugged into the socket of a vehicle. That is, the channel network 102 is configured to cool the female contact pin, which receives its counterpart on vehicle side the inlet is followed by the transfer channel 122, which again is split into two main channels 104 of the fluid channel network. Similarly, the transfer channel 124 is connected to two main channels 104. The transfer channels 122, 124 transfer the fluid between the inlet 112 or outlet 114 and the fluid channel network 102 through the contact terminal 320, which connects the DC conductors with the contact pin 330 as shown in Fig. 3 in more detail further below. Inside the connection piece 120, the transfer channel 124 is split up into three outlet channels, whereas the inlet channel 112 leads directly into the transfer channel. The transfer channels 122, 124 are connected to the main channels 104 of the fluid channel network 102. The main channels are parallel to the cylinder axis of the contact pin 330. They have a thin and relatively broad shape, which is adapted to the cylinder of the contact pin 320, i.e. nestle against the contact pin on their inner side. The neighboring main channels of the inlet main channels and the outlet main channels are inter-connected by a couple of channels 206, which are called cross-links or cross-link channels in this disclosure. In Fig. 4 each pair of neighboring main channels 106 are linked to each other by three cross-link channels. Also the cross-link channels follow the cylindrical shape of the contact pin 320. The shapes and inter-connections may be designed such that a pressure loss is minimized. The sizes, shapes, and numbers of main channels and cross-link channels may be varied. For example, the cross-link channels may form a curve or a bow with the "peak" in the middle of the channel oriented to the vehicle-end of the contact pin.

Fig. 2 shows a synoptic scheme of the hydraulic circuit inside the connector, that is fluid flow of the fluid channel assembly 100. The arrows show the directions of the flow. The last digits of the reference signs in Fig. 2 correspond to those of the channels in Fig. 1. The fluid from the charging station flows through the inlet 112 and the transfer channel 222, i.e. along path 222, into two main channels 104 indicated as path 204 in Fig. 2. From there, the fluid flows via the crosslink paths 206 to the main channel paths 204 of the outlets 114. Thereafter, the fluid paths combine and the fluid flows via the transfer channel path 224 and the path 220 in the connection piece 120 to the outlet paths 214 and back to the charging station. The number of each type of paths and the rectangular directions as indicated in Fig. 2 may vary.

Fig. 3 shows a diagram of a cross section of a DC connector 300 for one polarity. The charging gun comprises two such DC connectors 300, one for DC+ and one for DC-. The cross section shows a DC conductor 332, that is, a DC+ or DC- conductor. The DC conductors 332 are attached to the contact terminal 320 and surrounded by tubes 114, which are the outlets of the fluid channel assembly. The inlet 112 is continued by the first single fluid transfer channel 122 for transferring the fluid through the contact terminal 320 to the fluid channel network 100 inside the contact pin 330 (not shown in Fig. 3). Similarly, the second single fluid transfer channel 124 transfers the fluid through the contact terminal 320 from the fluid channel network 100 to the outlet 114, whereby the fluid is distributed in the connection piece 120 inside the contact terminal 320 to three outlet channels (in Fig. 3 two outlet channels are shown). The contact pin 330 contains contact springs, which guarantee electrical contact with the car inlet (not shown in Fig. 3). They are placed in the interior side of the cylindrical pin 330, where 3 grooves are visible.

Fig. 4 shows a diagram of a DC connector 300 for one polarity in an exploded view. Three copper conductors 332 are shown and their respective outlet tubes 114. The conductors 332 are attached to the contact terminal 320. The outlet tubes 114 have fixation nuts 442 for fixing them to the copper conductors 332 and the contact terminal 320. The fluid channel network 102 is formed by structures, for example grooves, which are milled into the contact pin and which are covered by sleeve 440. The sleeve 440 is also made of copper.

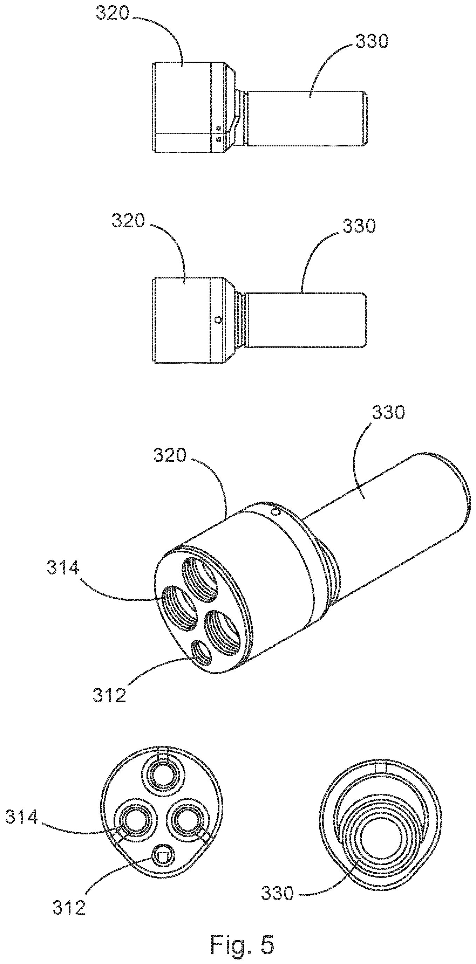

Fig. 5 shows a diagram with different views of the assembly of a contact terminal 320 and a contact pin 330. From top to bottom a side view, a top view, an oblique view, and a front view next to a rear view are presented. In the front view, the opening 312 for the inlet 112 and the openings 314 for the outlet tubes 114 and the DC conductors 332 are visible.

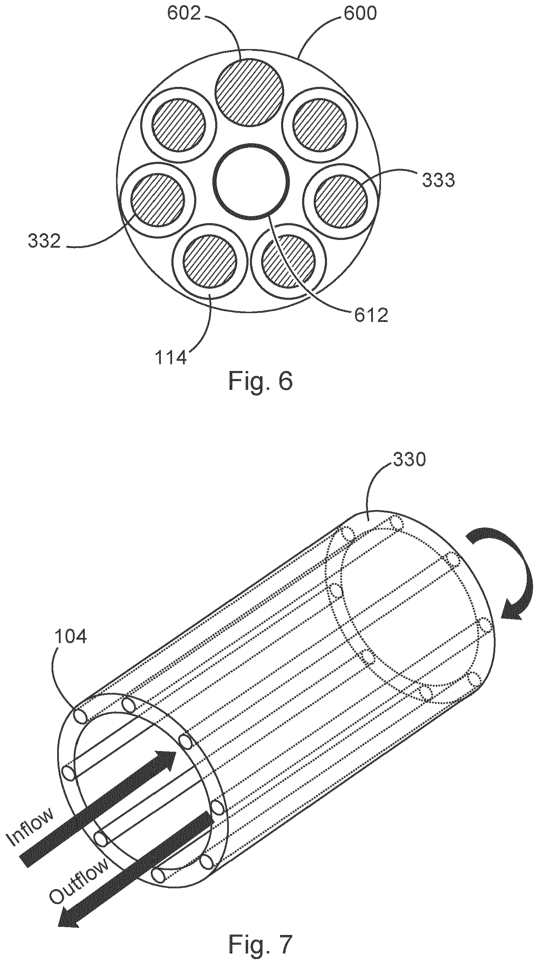

Fig. 6 shows a diagram of a cable with six DC conductors 332, three for DC+ ("x3") and three for DC- ("x3") as well as one PE conductor 602 ("x1") , i.e. a copper wire for the ground. The six DC conductors 332 are jacketed by the outflow tubes 114 so that the cooling fluid cools the cables 332 at the return flow. In the center, the inflow tube 612 for the fluid is arranged, which is surrounded by the seven conductors 332, 602. The cable 600 may have a different design than shown in Figure 6. The wires may have a cross section of 35 mm² for a total of 105 mm² per pole.

The design of the inlet and outlet ports may be varied in number and shape can be designed in function of the specific cable design. The coolant channels inside the connector, in particular in the fluid channel network, can be adapted in shape, number, and dimensions in function of the required thermal performances. Coolant channels inside the connector can be designed with different cross-section and dimensions in function of manufacturing process constraints. For instance, as shown in Fig. 7, the contact pin 330 may contain axial bores, which are at the front edge connected using a tip, which is brazed or welded, in such a way to provide a sufficient cooling profile. Further, additive manufacturing could provide a means of fabrication to produce complex shaped internal cooling channels with which very defined cooling profiles could be achieved. The contact terminal can be designed to be removable to improve after-sales operations such as aged contact spring change or failure repairs.

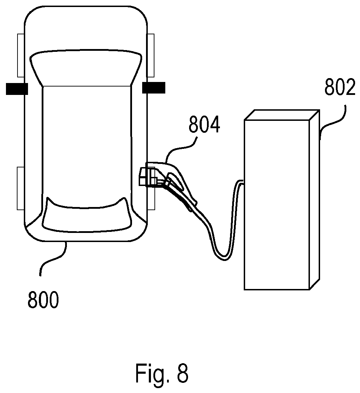

Fig. 8 shows a diagram of an electric vehicle 800, which is connected to a charging gun 804 of a charging station 802.

Other variations to the disclosed embodiments can be understood and effected by those skilled in the art in practicing the claimed invention, from the study of the drawings, the disclosure, and the appended claims. In the claims, the word "comprising" does not exclude other elements or steps and the indefinite article "a" or "an" does not exclude a plurality. A single processor or other unit may fulfill the functions of several items or steps recited in the claims. The mere fact that certain measures are recited in mutually different dependent claims does not indicate that a combination of these measures cannot be used to advantage. Any reference signs in the claims should not be construed as limiting the scope of the claims.

### Reference signs

- 100: Fluid channel assembly
- 102: Fluid channel network
- 104: Main channels
- 106: Cross-links, cross-link channels
- 112: Inlet (inflow tube connector), inlet channel
- 114: Outlet (outflow tube connector), outlet channels
- 120: Connection piece
- 122: First single fluid transfer channel
- 124: Second single fluid transfer channel
- 204: Fluid path of main channels
- 206: Fluid path of cross-links
- 212: Fluid path of inlet
- 214: Fluid path of outlet
- 220: Fluid path inside contact terminal
- 222: Fluid path of first single fluid transfer channel
- 224: Fluid path of second single fluid transfer channel
- 300: Connector
- 312: Opening for inlet
- 314: Opening for conductor and outlet
- 320: Contact terminal
- 330: Female contact pin
- 332: DC conductor (e.g. DC+ or DC-)
- 440: Sleeve
- 442: Fixation Nuts
- 600: Cable
- 602: PE conductor; neutral line
- 612: Inflow tube
- 800: Electric vehicle
- 802: Charging station
- 804: Charging gun

## Claims

1. Fluid channel assembly (100) for a connector (300) of an Electric Vehicle, EV, charging gun (804), comprising
a fluid channel network (102) for cooling a contact pin (330) of the EV charging gun (804);
a fluid inlet (112) connected to the fluid channel network (102), the fluid inlet (112) being configured to receive a coolant through an EV charging cable and to inject the coolant into the fluid channel network (102);
a fluid outlet (114) connected to the fluid channel network (102), the fluid outlet (114) being configured to receive the coolant from the fluid channel network (102) and to inject the coolant into the EV charging cable;
wherein the fluid channel network (102) is arranged around the contact pin (330) and wherein the fluid in the channel network (102) is in direct or indirect contact with the contact pin (330).

2. Fluid channel assembly (100) according to claim 1, wherein the inlet (112) is connected via a first single fluid transfer channel (122) with the fluid channel network (102).

3. Fluid channel assembly (100) according to claim 1 or 2, wherein the at least one outlet (114) is connected via a second single fluid transfer channel (124) with the fluid channel network (102).

4. Fluid channel assembly (100) according to any of the previous claims, wherein the fluid channel network (102) has main channels (104) parallel to the axis of the contact pin (330) and cross-link channels (106) between the main channels (104).

5. Fluid channel assembly (100) according to the previous claim, wherein each transfer channel splits into two main channels (104), and a part of the cross-link channels (106) connects one of the main channels (104) of the first single fluid transfer channel (122) with a neighboring main channel of the second single fluid transfer channel (124).

6. Fluid channel assembly (100) according to claims 4 or 5, wherein the number of cross-link channels (106) is two or more.

7. Fluid channel assembly (100) according to claims 2 and 3, or 4 to 6, comprising further a contact terminal,
wherein the fluid inlet (112) and the fluid outlet (114) are mounted on a first side of the contact terminal, and the first and second single fluid transfer channels (124) are mounted on a second side of the contact terminal; and
wherein the inlet (112) is continued to the first single fluid transfer channel (122) through the contact terminal; and
wherein the second single fluid transfer channel (124) is split into a plurality of outlet (114) ports of the outlets (114) inside the contact terminal.

8. Connector (300) for an Electric Vehicle, EV, charging station; wherein the Connector (300) comprises
a fluid channel assembly (100) according to any of the previous claims comprising an inlet (112), an outlet (114), transfer channels and a fluid channel network (102);
a contact pin (330);
a contact terminal (320) comprising an outlet (114) for connecting outflow tubes, an inlet (112) for connecting an inflow tube, and means for connecting the at least one copper conductor on a first side and means for connecting the contact pin (330) on a second side; wherein the contact terminal is configured to accommodate the first and the second single fluid transfer channels (122, 124); and
wherein the fluid channel network (102) is arranged around the contact pin (330) and the fluid in the channel network (102) is in direct or indirect contact with the DC contact pin (330).

9. Connector (300) according to the previous claim, wherein the connector (300) further comprises a sleeve (440) for the contact pin (330) covering the contact pin (330); and wherein the channels of the fluid channel network (102) are formed by grooves on the surface of the contact pin (330) covered by the sleeve (440).

10. Charging gun for an EV charging station comprising a first connector (300) according to claim 8 or 9 a second connector (300) according to claim 8 or 9, wherein the first connector (300) is a DC+ connector (300) for providing a positive DC pole, and the second connector (300) is a DC- connector (300) for providing a negative DC pole; wherein
the charging gun further comprises a charging cable with a least one DC+ conductor connected to the DC+ Connector (300), at least one DC- conductor connected to the DC-connector (300), at least a first outflow tube, at least a second outflow tube, and an inflow tube; and wherein
the at least one DC+ conductor is configured to receive the at least one first outflow tube, and the at least one first outflow tube is connected to the outlet (114) of the DC+ contact terminal;
the at least one DC- conductor is configured to receive the at least one second outflow tube, and the at least one second outflow tube is connected to the outlet (114) of the DC- contact terminal.

11. Charging gun (804) according to the previous claim, wherein the connector (300) comprises three DC+ copper conductors and three DC- conductors;
wherein the three DC+ conductors, the three DC- conductors, and the inlet (112) are part of a charging cable; and
wherein the three DC- conductors and the three DC- conductors each are jacketed by an outflow tube, and the three outflow tubes of the three DC+ conductors form an outlet (114) of the fluid channel network (102) of the DC+ contact pin (330);
and wherein the three outflow tubes of the three DC- conductors form an outlet (114) of the fluid channel network (102) of the DC- contact pin (330).

12. Charging gun (804) according to the previous claim, wherein the charging cable (600) further comprises a neutral line (602);
wherein the inflow tube is arranged centrally in the cable, and wherein the three DC+ conductors, the three DC- conductors, and the neutral line are arranged are surrounding the inflow tube.

13. Charging station (802) comprising a charging gun (804) according to any of claims 10-12.

14. Use of a fluid channel network (102) in an EV connector (300) for cooling a contact pin (330) of an EV connector (300).
